# EUROPÄISCHE PATENTANMELDUNG

(11) **EP 3 051 321 A1**
(43) Veröffentlichungstag der Anmeldung: **03.08.2016**
(21) Anmeldenummer: 16152789.0
(22) Anmeldetag: 26.01.2016
(51) Int. Cl.: G02B 1/111, G02B 1/118, B29C 59/14

(54) **VERFAHREN ZUR HERSTELLUNG EINES REFLEXIONSMINDERNDEN SCHICHTSYSTEMS UND REFLEXIONSMINDERNDES SCHICHTSYSTEM**

(30) Priorität: 27.01.2015 DE 102015101135
(71) Anmelder: Fraunhofer-Gesellschaft zur Förderung der angewandten Forschung e.V., 80686 München (DE)
(72) Erfinder: Schulz, Ulrike, 07751 Jena (DE); Rickelt, Friedrich, 07745 Jena (DE); Munzert, Peter, 07743 Jena (DE); Heiße, Hanno, 07747 Jena (DE); Knopf, Heiko, 07745 Jena (DE); Füchsel, Kevin, 07747 Jena (DE); Kaiser, Norbert, 07745 Jena (DE)
(74) Vertreter: Epping - Hermann - Fischer

(57) **Zusammenfassung**

Es wird ein Verfahren zur Herstellung eines reflexionsmindernden Schichtsystems auf einem Substrat (10) angegeben, umfassend die Schritte:
- Abscheidung einer Brechzahlgradientenschicht (1) auf das Substrat (10) durch Ko-Verdampfung eines anorganischen Materials und eines organischen Materials, wobei die Brechzahlgradientenschicht (1) eine in Wachstumsrichtung abnehmende Brechzahl aufweist,
- Abscheidung einer organischen Schicht (2) über der Brechzahlgradientenschicht (1), und
- Erzeugung einer Nanostruktur (12) in der organischen Schicht (2) durch einen Plasmaätzprozess. Weiterhin wird ein auf diese Weise herstellbares reflexionsminderndes Schichtsystem beschrieben.

## Beschreibung

Die Erfindung betrifft ein reflexionsminderndes Schichtsystem und eine Verfahren zu dessen Herstellung auf einem Substrat, insbesondere auf einem gekrümmten Glas- oder Kunststoffsubstrat für optische Anwendungen.

Diese Patentanmeldung beansprucht die Priorität der deutschen Patentanmeldung DE 10 2015 101 135.2, deren Offenbarungsgehalt hiermit durch Rückbezug aufgenommen wird.

Zur Entspiegelung von Oberflächen, insbesondere von optischen Elementen oder Displays, werden üblicherweise reflexionsmindernde Interferenzschichtsysteme verwendet, die mehrere alternierende Schichten aus hochbrechenden und niedrigbrechenden Materialien enthalten. Als Material mit einer besonders niedrigen Brechzahl im sichtbaren Spektralbereich wird derzeit MgF₂ mit n = 1,38 eingesetzt. Die Entspiegelungswirkung herkömmlicher dielektrischer Schichtsysteme könnte verbessert werden, wenn Materialien mit geringerer Brechzahl zur Verfügung stehen würden.

Eine alternative Möglichkeit zur Verminderung der Reflexion eines optischen Elements ist aus der Patentschrift DE 10241708 B4 bekannt. Bei diesem Verfahren wird an der Oberfläche eines Kunststoffsubstrats mittels eines Plasmaätzprozesses eine Nanostruktur erzeugt, durch die die Reflexion des Kunststoffsubstrats vermindert wird. Die Entspiegelung eines optischen Elements durch die Erzeugung einer Nanostruktur an dessen Oberfläche hat den Vorteil, dass eine geringe Reflexion über einen weiten Einfallswinkelbereich erzielt wird.

Die Druckschrift DE 102008018866 A1 beschreibt ein reflexionsminderndes Interferenzschichtsystem, auf das eine organische Schicht aufgebracht wird, die mittels eines Plasmaätzprozesses mit einer Nanostruktur versehen wird.

Allerdings erreichen plasmageätzte Nanostrukturen auf den meisten Materialien nur eine Tiefe von 100 nm bis 200 nm. Eine solche Dicke ist für ebene und leicht gekrümmte Oberflächen ausreichend, um ein Substrat im visuellen Spektralbereich von 400 nm bis 700 nm für Lichteinfallswinkel von 0° (senkrechter Lichteinfall) bis 60° so zu entspiegeln, dass die Restreflexion nur etwa 1% beträgt. Teilweise werden aber breitbandige Entspiegelungen gefordert, die über noch größere Lichteinfallswinkelbereiche funktionieren sollen.

Ein besonderes Problem stellt die Herstellung einer Entspiegelungsschicht auf niedrigbrechenden (n < 1.7) stark gekrümmten Oberflächen dar. Eine durch einen gerichteten Vakuumbeschichtungsprozess wie Sputtern oder Aufdampfen abgeschiedene Schicht hat an dem Ort, an dem sie aufwächst, eine Dicke, die vom Winkel des auftreffenden Dampfes abhängt. Die Schichtdicke nimmt mit zunehmendem Auftreffwinkel ab. Bei einem Interferenzschichtsystem nimmt daher die physikalische Dicke d aller Schichten mit zunehmendem Auftreffwinkel ab. Für die optische Funktion ist jedoch die optische Dicke n * d von Bedeutung, wobei n die Brechzahl ist. Die Brechzahl n ist bei den aus hochbrechenden und niedrigbrechenden Materialien bestehenden Schichtsystemen unterschiedlich, so dass sich die optische Funktion bei variierender Dicke zusätzlich verändert. Aufgrund dieser Problematik weist die Restreflexion von Antireflexschichten im Randbereich von Linsen in der Regel unerwünscht hohe Werte auf.

Eine Verbesserung könnte erzielt werden, wenn man eine niedrigbrechende Gradientenschicht so dick herstellen könnte, dass ein Dickenabfall von mindestens 50% toleriert wird. Die technische Realisierung auf hochbrechenden Substraten (n > 1,7) gestaltet sich einfacher als auf den gebräuchlichen niedrigbrechenden Gläsern, da schon mit natürlichen Materialien ein Schichtaufbau realisierbar ist, bei dem die Brechzahl allmählich abnimmt.

Für die Herstellung relativ dicker Schichten mit effektiver Brechzahl < 1,38 gibt es technisch nur wenige Möglichkeiten. In der Druckschrift W. Joo , H.J. Kim and J.K. Kim, "Broadband Antireflection Coating Covering from Visible to Near Infrared Wavelengths by Using Multilayered Nanoporous Block Copolymer Films", Langmuir 26(7), 2010, 5110-5114, wird die Herstellung einer dicken Gradientenschicht mittels Sol-Gel-Prozessen beschrieben, wobei hier aber die Abscheidung auf gekrümmten Oberflächen schwierig sein könnte.

Ein vakuumtechnisches Verfahren zur Herstellung mehrschichtiger Gradientenschichten ist aus der Druckschrift S.R. Kennedy, M.J. Brett, "Porous Broadband Antireflection Coating by Glancing Angle Deposition", Appl Opt. 42, 4573-4579, 2003, bekannt. Dabei werden Oxide oder Fluoride unter schrägem Winkel auf das Substrat aufgedampft. Durch Abschattungseffekte entstehen hier ebenfalls poröse Schichten. Das Substrat muss aus diesem Grund also schräg zum Dampfeinfallswinkel positioniert werden. Auf einer stark gekrümmten Oberfläche würde es jedoch zu zusätzlichen Abschattungseffekten durch die Linsengeometrie kommen, so dass das Verfahren für gekrümmte Linsen nicht ohne weiteres angewendet werden kann.

Die Druckschrift WO 2014/202375 A1 beschreibt ein reflexionsminderndes Schichtsystem, das zwei übereinander angeordnete nanostrukturierte Schichten aufweist. Hierdurch wird eine breitbandige Entspiegelung erzielt, allerdings können durch die innere nanostrukturierte Schicht möglicherweise Streulichtverluste entstehen.

Der Erfindung liegt die Aufgabe zugrunde, ein verbessertes reflexionsminderndes Schichtsystem und ein Verfahren zu dessen Herstellung anzugeben, mit dem verschiedene Oberflächen breitbandig und winkelunabhängig entspiegelt werden können, wobei sich das reflexionsmindernde Schichtsystem insbesondere durch eine geringe Lichtstreuung und eine verbesserte Haftung auf einem Substrat auszeichnen soll.

Diese Aufgabe wird durch ein Verfahren zur Herstellung eines reflexionsmindernden Schichtsystems und ein reflexionsminderndes Schichtsystem gemäß den unabhängigen Patentansprüchen gelöst. Vorteilhafte Ausgestaltungen und Weiterbildungen der Erfindung sind Gegenstand der abhängigen Ansprüche.

Gemäß zumindest einer Ausgestaltung des Verfahrens zur Herstellung des reflexionsmindernden Schichtsystems auf einem Substrat wird in einem ersten Schritt eine Brechzahlgradientenschicht durch Ko-Verdampfung eines anorganischen Materials und eines organischen Materials auf dem Substrat abgeschieden. Die Brechzahlgradientenschicht weist vorteilhaft eine in Wachstumsrichtung abnehmende Brechzahl auf. Die Brechzahl der Brechzahlgradientenschicht nimmt also ausgehend vom Substrat zur Oberfläche des reflexionsmindernden Schichtsystems hin ab. Besonders bevorzugt vermindert sich die Brechzahl der Brechzahlgradientenschicht in Wachstumsrichtung kontinuierlich, also ohne Stufen.

Gemäß zumindest einer Ausgestaltung wird in einem nachfolgenden Schritt eine organische Schicht über der Brechzahlgradientenschicht abgeschieden und eine Nanostruktur in der organischen Schicht durch einen Plasmaätzprozess erzeugt. Auf diese Weise wird vorteilhaft ein Brechzahlgradient in der Schicht aus dem organischen Material erzeugt, wobei die Brechzahl der organischen Schicht in Wachstumsrichtung, d.h. in einer vom Substrat zur Oberfläche verlaufenden Richtung, abnimmt. Die Nanostruktur weist vorzugsweise eine Vielzahl von Strukturelementen auf, deren Höhen im Mittel zwischen 80 nm und 130 nm betragen. Die Abstände der Strukturelemente, d.h. die Distanzen zwischen jeweils benachbarten Erhöhungen der Nanostruktur, betragen vorteilhaft im Mittel weniger als 100 nm.

Das so hergestellte reflexionsmindernde Schichtsystem zeichnet sich insbesondere dadurch aus, dass die Brechzahl sowohl in der Brechzahlgradientenschicht, die durch Ko-Verdampfung des anorganischen und organischen Materials hergestellt wird, als auch in der nachfolgenden organischen Schicht, welche mit einer Nanostruktur versehen wird, jeweils in der vom Substrat zu Oberfläche des reflexionsmindernden Schichtsystems zeigenden Richtung abnimmt. Insgesamt wird auf diese Weise eine über einen vergleichsweise großen Dickenbereich abnehmende Brechzahl erzielt. Dies hat den Vorteil, dass auch auf gekrümmten Substraten eine sehr gute Entspiegelung in einem großen Winkelbereich erzielt wird.

Weiterhin zeichnet sich das reflexionsmindernde Schichtsystem durch eine vergleichsweise geringe Lichtstreuung aus, da die Nanostruktur nur an der Oberfläche des Schichtsystems ausgebildet ist. Die Lichtstreuung des hier beschriebenen reflexionsmindernden Schichtsystems ist insbesondere im Vergleich zu alternativen reflexionsmindernden Schichtsystemen gering, bei denen mehrere nanostrukturierte und/oder poröse Schichten übereinander angeordnet sind.

Die Herstellung der an das Substrat angrenzenden Brechzahlgradientenschicht durch Ko-Verdampfung eines anorganischen und eines organischen Materials hat außerdem den Vorteil, dass die elastischen und thermoelastischen Eigenschaften der Brechzahlgradientenschicht an das Substratmaterial angepasst werden können. Das Substrat kann zum Beispiel ein Kunststoffsubstrat sein. Es ist bekannt, dass anorganische Schichten wie zum Beispiel MgF2 oftmals schlecht auf Kunststoffen haften, da die bei niedrigen Temperaturen abgeschiedenen Schichten in der Regel Zugspannungen aufweisen. Solche Schichten bilden bei Erwärmung leicht Risse aus, insbesondere wenn, wie bei Kunststoffen der Fall, die thermische Ausdehnung des Substratmaterials deutlich höher ist, als die der Schicht. Durch die hier vorgeschlagene Beimischung eines organischen Materials zu dem anorganischen Material kann vorteilhaft die Zugspannung der an das Substrat angrenzenden Brechzahlgradientenschicht vermindert und so eine verbesserte Haftung auf dem Substrat erzielt werden.

Die Konzentration des organischen Materials in der Brechzahlgradientenschicht kann an der Grenzfläche zum Substrat insbesondere 95 % oder weniger betragen.

Die Konzentration des organischen Materials beträgt im oberstem Bereich, d.h. an der vom Substrat abgewandten Grenzfläche der Brechzahlgradientenschicht, vorzugsweise 5 % oder weniger.

Die Brechzahlgradientenschicht weist vorteilhaft eine Dicke zwischen 70 nm und 200 nm, bevorzugt etwa 150 nm, auf.

Dass anorganische Material der Brechzahlgradientenschicht weist vorzugsweise eine Brechzahl n1 mit 1,37 ≤ n1 ≤ 1,46 auf. Dass anorganische Material kann insbesondere ein Oxid oder Fluorid sein. Besonders bevorzugt ist das anorganische Material Magnesiumfluorid (MgF₂) oder Siliziumdioxid (SiO₂). Alternativ sind auch Fluoride wie zum Beispiel AlF₃ oder Fluoridmischungen wie zum Beispiel Krylit, die eine Brechzahl von weniger als 1,4 aufweisen, besonders gut geeignet.

Das organische Material der Brechzahlgradientenschicht weist vorteilhaft eine Brechzahl n2 auf, die größer als die Brechzahl n1 des anorganischen Materials ist. Besonders bevorzugt ist 1,6 ≤ n2 ≤ 1,9. Bevorzugt wird als organisches Material Melamin verwendet.

Die räumlich variierende Brechzahl n_{gl} (z) der Brechzahlgradientenschicht, wobei z eine in Wachstumsrichtung zeigende Ortskoordinate ist, kann vorteilhaft durch eine räumliche Variation der Konzentrationen des anorganischen Materials und des organischen Materials zwischen dem Brechungsindex n1 des anorganischen Materials und dem Brechungsindex n2 des organischen Materials variiert werden. Insbesondere ist also n1 ≤ n_{gl} (z) ≤ n2.

Die Brechzahlgradientenschicht wird vorteilhaft durch Vakuumabscheidung, insbesondere durch plasmaionengestützte Abscheidung, hergestellt. Zur plasmaionengestützten Abscheidung der Brechzahlgradientenschicht wird vorteilhaft eine Ionenquelle verwendet, welche Ionen mit vergleichsweise niedrigen Ionenenergien zwischen 45 eV und 60 eV erzeugt. Die Ionenquelle wird vorzugsweise mit Stickstoff oder einem anderen Inertgas betrieben.

Der Konzentrationsgradient in der Brechzahlgradientenschicht wird insbesondere dadurch erzeugt, dass die auf das Substrat auftreffenden Teilchenströme des organischen Materials und des anorganischen Materials während des Wachstums der Brechzahlgradientenschicht variiert werden. Hierzu wird mindestens ein Parameter variiert, welcher den Teilchenstrom und somit die Abscheiderate des anorganischen und/oder des organischen Materials am Substrat beeinflusst. Zur Messung der Abscheideraten kann zum Beispiel ein Schwingquarzmesssystem eingesetzt werden. Bei der Verwendung von Verdampfungsquellen zur Abscheidung wird beispielsweise die Heizleistung der Verdampfungsquellen während der Abscheidung der Brechzahlgradientenschicht zeitlich variiert.

Vorzugsweise wird die Brechzahl der Brechzahlgradientenschicht an der Grenzfläche zum Substrat an eine Brechzahl des Substrats angepasst. Hierzu werden beim Beginn des Aufwachsen der Brechzahlgradientenschicht die Konzentrationen des anorganischen Materials und des organischen Materials so gewählt, dass die Brechzahl der Brechzahlgradientenschicht im Bereich der Grenzfläche zum Substrat im Wesentlichen mit der Brechzahl des Substrats übereinstimmt. Vorzugsweise weicht die Brechzahl der Brechzahlgradientenschicht im Bereich der Grenzfläche zum Substrat um nicht mehr als 0,1, besonders bevorzugt nicht mehr als 0,05 von der Brechzahl des Substrats ab. Durch die Anpassung der Brechzahl der Brechzahlgradientenschicht an das Substrat wird eine besonderes gute Entspiegelung erzielt, da insbesondere die Reflexion an der Grenzfläche zwischen dem Substrat und der angrenzenden Brechzahlgradientenschicht minimiert wird.

Bei einer vorteilhaften Ausgestaltung ist das organische Material der Brechzahlgradientenschicht ein UV-absorbierendes Material. Durch die Verwendung eines UV-absorbierenden Materials lässt sich vorteilhaft die Zusatzfunktion eines UV-Schutzes in das reflexionsmindernde Schichtsystem integrieren. Geeignete UV-absorbierende Materialien sind zum Beispiel 2,2'-methylenebis(6-(2H-benzotriazol-2-yl)-4-1,1,3,3-tetramethylbutyl)phenol (MBP), 2-(4,6-diphenyl-1,3,5-triazi-2-yl)-5[(hexyl)oxy]-phenol (Tinuvin 1577), Ethyl-2-cyano-3-(4-hydroxyphenyl)acrylat (semaSORB 20106), Methyl-2-cyano-3-(4-hydroxyphenyl)acrylat (semaSORB 20163), N-[3-(2H-benzotriazol-2-yl)-2-hydroxy-5(tert-octyl)phenyl]-N'-phenylharnstoff (semaSORB UV180) oder Propansäure,2-[4-[4,6-bis([1,1'-biphenyl]-4-yl)-1,3,5-triazin-2-yl]-3-hydroxyphenoxy]-,isooctyl-ester (Tinuvin 479).

Die über der Brechzahlgradientenschicht angeordnete organische Schicht wird gemäß einer bevorzugten Ausgestaltung mit einer Schichtdicke zwischen 250 nm und 400 nm aufgebracht. Bei einer Schichtdicke in diesem Bereich ist die organische Schicht einerseits dick genug, dass eine ausreichend tiefe Nanostruktur in ihr erzeugt werden kann, und andererseits dünn genug, dass in ihr ein bis in den Bereich der Grenzfläche zur darunter liegenden durch Ko-Verdampfung erzeugten Brechzahlgradientenschicht reichender Brechzahlgradient erzeugt werden kann.

Die organische Schicht wird vorzugsweise mittels plasmaionengestützter Abscheidung aufgebracht. Wie bei der Abscheidung der Brechzahlgradientenschicht wird vorteilhaft eine Ionenquelle verwendet, welche Ionen mit vergleichsweise niedrigen Ionenenergien zwischen 45 eV und 60 eV erzeugt. Die Ionenquelle wird vorzugsweise mit Stickstoff oder einem anderen Inertgas wie zum Beispiel Argon betrieben.

Die organische Schicht weist vorzugsweise zumindest bereichsweise eine effektive Brechzahl zwischen 1,05 und 1,38 auf. Unter der effektiven Brechzahl ist hier und im Folgenden die über die Nanostruktur gemittelte Brechzahl zu verstehen, deren Wert aufgrund der durch die Nanostruktur erzeugten Ausnehmungen in der organischen Schicht vorteilhaft geringer ist als die Brechzahl einer kontinuierlichen Schicht aus dem Material der organischen Schicht. Vorteilhaft weist die organische Schicht an der Oberfläche einen mindestens 100 nm dicken Bereich auf, in dem die effektive Brechzahl weniger als 1,20, bevorzugt weniger als 1,15 beträgt.

Für die organische Schicht ist vorteilhaft eine Vielzahl von Materialien geeignet, in denen mittels eines Plasmaätzprozesses eine Nanostruktur erzeugt werden kann. Bevorzugt enthält die organische Schicht eines der folgenden Materialien: 2,4,6-Triamino-1,3,5-triazin (Melamin), 2,2'-methylenebis(6-(2H-benzotriazol-2-yl)-4-1,1,3,3-tetramethylbutyl)phenol (MBP), N,N'-Bis(3-methylphenyl)-N,N'-diphenylbenzidin (TPD), N,N'-Di(naphth-1-yl)-N,N'-diphenyl-benzidin (NPB), N,N,N',N'-Tetraphenylbenzidin (TPB), Tris(4-carbazoyl-9-ylphenyl)amin (TCTA) .

Weiterhin sind die zuvor für das organische Material der Brechzahlgradientenschicht genannten UV-absorbierenden Materialien auch für die organische Schicht geeignet.

Bei einer Ausgestaltung des Verfahrens wird vor dem Aufbringen der organischen Schicht eine anorganische Zwischenschicht auf die Nanostruktur aufgebracht. Die anorganische Zwischenschicht weist vorzugsweise SiO₂ auf. Die Schichtdicke der anorganischen Zwischenschicht beträgt vorteilhaft zwischen 2 nm und 15 nm. Die anorganische Zwischenschicht wird vorzugsweise mittels plasmaionengestützter Abscheidung hergestellt, wodurch eine Verdichtung der Schicht während des Aufwachsens erzielt wird. Vorzugsweise wird ein Argon- oder Sauerstoffplasma verwendet, so dass eine aktivierte Oberfläche vorliegt. Die anorganische Zwischenschicht kann insbesondere die Funktion einer Haftvermittlerschicht haben.

Bei einer weiteren vorteilhaften Ausgestaltung des Verfahrens wird nach der Erzeugung der Nanostruktur eine anorganische Schutzschicht auf die Nanostruktur aufgebracht. Die anorganische Schutzschicht ist vorzugsweise eine SiO₂-Schicht oder eine MgF₂-Schicht, wobei sich diese Materialien insbesondere durch eine geringe Brechzahl auszeichnen. Die Schutzschicht weist vorteilhaft eine Dicke zwischen 10 nm und 50 nm auf. Dies hat den Vorteil, dass die effektive Brechzahl an der Oberfläche der Nanostruktur durch die Schutzschicht nur unwesentlich beeinflusst wird. Vorzugsweise wird die effektive Brechzahl der nanostrukturierten organischen Schicht durch das Aufbringen der Schutzschicht um nicht mehr als 0,1 erhöht.

Das Aufbringen der Schutzschicht erfolgt vorzugsweise durch Aufdampfen, wobei es sich um einen gerichteten Abscheideprozess handelt. Es hat sich herausgestellt, dass das Material der Schutzschicht beim Aufdampfen bevorzugt auf den Erhebungen der Nanostruktur abgeschieden wird. Alternativ kann die Schutzschicht durch PECVD (Plasma Enhanced Chemical Vapor Deposition) aufgebracht werden, insbesondere durch Polymerisation eines geeigneten Silizium-organischen Precursors.

Gemäß zumindest einer vorteilhaften Ausgestaltung wird das gesamte reflexionsmindernde Schichtsystem in einem Vakuumprozess hergestellt. Insbesondere werden alle in dem reflexionsmindernden Schichtsystem enthaltenen Schichten durch Vakuumabscheidung aufgebracht und die Nanostruktur durch einen Plasmaätzprozess erzeugt. Dadurch, dass alle Herstellungsschritte in einem einzigen Vakuumprozess erfolgen können, wird der Herstellungsaufwand vorteilhaft vermindert.

Bei einer besonders bevorzugten Ausgestaltung wird die organische Schicht, vorzugsweise eine Melamin-Schicht, durch plasma-ionengestützte Abscheidung unter Verwendung einer Plasmaionenquelle hergestellt, wobei die Nanostruktur nachfolgend durch eine Erhöhung der Ionenenergie die und/oder eine Änderung des Prozessgases der Plasma-Ionenquelle erzeugt wird. Das Aufwachsen und Strukturieren der organischen Schicht kann so in einem einzigen Verfahrensschritt, bei dem die Betriebsparameter der Plasmaionenquelle geändert werden, erfolgen. Beispielsweise erfolgt bei der Abscheidung der organischen Schicht zunächst eine Ionenstützung mit Argon, Stickstoff oder einem anderen Inertgas durch die Plasmaionenquelle bei Ionenenergien zwischen vorzugsweise 45 eV und 60 eV. Zur Erzeugung der Nanostruktur wird dann die Ionenquelle zum Beispiel mit Sauerstoff betrieben und die Ionenenergie auf 80 eV bis 150 eV erhöht.

Das mit den zuvor beschriebenen Verfahren herstellbare reflexionsmindernde Schichtsystem umfasst vorteilhaft eine Brechzahlgradientenschicht, die ein anorganisches Material und ein organisches Material in einer räumlich variierenden Zusammensetzung aufweist, wobei die Brechzahlgradientenschicht eine in Wachstumsrichtung abnehmende Brechzahl aufweist. Über der Brechzahlgradientenschicht ist bei dem reflexionsmindernden Schichtsystem eine organische Schicht angeordnet, die eine mit einer Nanostruktur versehen Oberfläche aufweist. Die Nanostruktur weist bevorzugt eine Vielzahl von Strukturelementen auf, deren Höhen im Mittel zwischen 80 nm und 130 nm und deren Abstände im Mittel weniger als 100 nm betragen. Die Nanostruktur in der organischen Schicht bewirkt vorteilhaft, dass auch die organische Schicht eine in Wachstumsrichtung abnehmende Brechzahl aufweist. Auf diese Weise wird vorteilhaft eine über einen vergleichsweise großen Bereich abnehmende Brechzahl in dem reflexionsmindernden Schichtsystem erzielt. Die Gesamtdicke des reflexionsmindernden Schichtsystems beträgt vorzugsweise zwischen 250 nm und 450 nm.

Das reflexionsmindernde Schichtsystem kann insbesondere auf ein gekrümmtes Substrat aufgebracht sein. Auf gekrümmten Substraten hat das reflexionsmindernde Schichtsystem den Vorteil, dass eine geringe Restreflexion auch dann erzielt wird, wenn sich die Dicken der Einzelschichten und somit die Gesamtdicke des reflexionsmindernden Schichtsystems zu den Rändern des Substrats hin aufgrund der geringeren Abscheideraten auf den geneigten Flächenbereichen verringern. Mit anderen Worten ist das reflexionsmindernde Schichtsystem tolerant gegenüber Änderungen der Schichtdicke. Das Substrat kann insbesondere derart stark gekrümmt sein, dass mindestens ein Teilbereich der Substratoberfläche um mindestens 45° oder sogar um mindestens 60° zu einem anderen Teilbereich der Oberfläche geneigt ist.

Insbesondere kann mit dem reflexionsmindernden Schichtsystem selbst in einem geneigten Flächenbereich eine mittlere Reflexion von weniger als 1,5 % oder bevorzugt sogar weniger 1 % im sichtbaren Spektralbereich erzielt werden, wenn die Dicke des reflexionsmindernden Schichtsystems in dem geneigten Flächenbereich um bis zu 50 % geringer ist als in einem Bereich, in dem die Abscheidung mit einer im wesentlichen senkrechten Dampfeinfallsrichtung erfolgt. Es kann zum Beispiel im Mittenbereich auf einem gekrümmten Substrat eine Restreflexion von weniger als 0,5 % erzielt werden, wobei die Restreflexion selbst in einem Randbereich mit einem Neigungswinkel von 60° noch weniger als 1,5 % beträgt.

Das reflexionsmindernde Schichtsystem ist aber auch für ebene Substrate von Vorteil, insbesondere wenn eine breitbandige Entspiegelung über einen großen Wellenlängen- und/oder Einfallswinkelbereich erzielt werden soll.

Das Substrat des reflexionsmindernden Schichtsystems kann insbesondere ein Kunststoffsubstrat sein, wobei das reflexionsmindernde Schichtsystem aber auch zur Entspiegelung anderer Materialien wie beispielsweise Glas eingesetzt werden kann. Das reflexionserhöhende Schichtsystem kann insbesondere zur Entspiegelung von optischen Elementen wie zum Beispiel Linsen eingesetzt werden.

Weitere vorteilhafte Ausgestaltungen des reflexionsmindernden Schichtsystems ergeben sich aus der vorherigen Beschreibung des Verfahrens und umgekehrt.

Die Erfindung wird im Folgenden im Zusammenhang mit den Figuren 1 bis 7 näher erläutert.

Es zeigen:
- Figur 1: eine schematische Darstellung einer als Substrat fungierenden Linse mit sphärischer Oberfläche mit einer Illustration der Schichtdickenänderung bei verschiedenen Dampfeinfallswinkeln,
- Figur 2: eine grafische Darstellung von Reflexionsspektren an Positionen A und B der in Fig. 1 gezeigten Linse für ein konventionelles Interferenzschichtsystem aus 4 Schichten (V1) sowie für eine Einfachschicht aus MgF₂ (V2),
- Figuren 3A bis 3F: eine schematische Darstellung eines Ausführungsbeispiels des Verfahrens zur Herstellung des reflexionsmindernden Schichtsystems anhand von Zwischenschritten,
- Figur 4: eine grafische Darstellung des Verlaufs der effektiven Brechzahl n_{eff} für ein erstes und ein zweites Ausführungsbeispiel des reflexionsmindernden Schichtsystems,
- Figur 5: eine grafische Darstellung von Reflexionsspektren an Positionen A und B der in Fig. 1 gezeigten Linse für ein erstes Ausführungsbeispiel des reflexionsmindernden Schichtsystems,
- Figur 6: eine grafische Darstellung von Reflexionsspektren an Positionen A und B der in Fig. 1 gezeigten Linse für ein zweites Ausführungsbeispiel des reflexionsmindernden Schichtsystems, und
- Figur 7: eine grafische Darstellung von Reflexionsspektren für das erste und das zweite Ausführungsbeispiel des reflexionsmindernden Schichtsystems.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

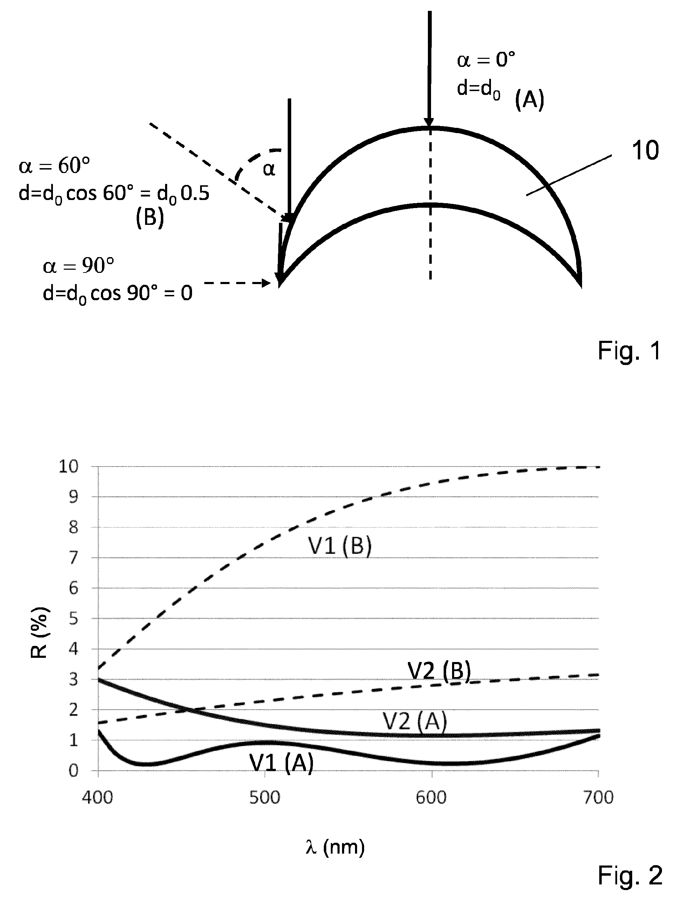

In Figur 1 ist schematisch eine sphärische Linse dargestellt, die mit einer Entspiegelungsschicht versehen werden soll. Die sphärische Linse fungiert somit als Substrat 10 für die Entspiegelungsschicht. Die Linse ist beispielsweise eine Glaslinse mit einer Brechzahl n_{S} = 1,53. Wenn eine Schicht mit einem gerichteten Vakuumbeschichtungsprozess wie beispielsweise Sputtern oder Aufdampfen auf der gekrümmten Oberfläche der Linse abgeschieden wird, hat die Schicht an dem Ort, an dem sie aufwächst, eine Dicke, die vom Winkel des auftreffenden Dampfes abhängt. Es ist allgemein bekannt, dass für die Schichtdicke d in Abhängigkeit vom Dampfeinfallswinkel α auf der Linse gilt: d(α) = d₀ * cos α.

Dabei ist d₀ die Schichtdicke in der Linsenmitte (senkrechter Dampfeinfall). Bei einer perfekten Halbkugel beträgt die Schichtdicke somit am äußersten Rand 0 nm, es wird zumindest theoretisch gar keine Schicht abgeschieden. In einem Punkt B der Linse, der einen Dampfeinfallswinkel α = 60° aufweist, beträgt der Schichtdickenabfall bereits 50% gegenüber dem Mittelpunkt A der Linse, auf den der Dampf senkrecht (α = 0°) auftrifft.

In Figur 2 wird der Einfluss des Schichtdickenabfalls zum Rand der Linse für nicht erfindungsgemäße Vergleichsbeispiele von herkömmlichen Entspiegelungsschichten verdeutlicht. Dargestellt ist die Reflexion R in Abhängigkeit von der Wellenlänge λ an den Punkten A und B der in Fig. 1 gezeigten Linse für ein konventionelles Interferenzschichtsystem aus vier Schichten (V1) sowie für eine Einfachschicht aus MgF₂ (V2). Die Grafik verdeutlicht, dass sich im Mittelpunkt A der Linse mit dem Interferenzschichtsystem V1 aus vier Schichten eine geringere Restreflexion erzielen lässt als mit der Einzelschicht V2. Im Punkt B, in dem die Schichtdicke um 50% reduziert ist, wird mit der Einzelschicht V2 eine geringere Restreflexion R und somit eine bessere Entspiegelung erzielt. Das mehrschichtige Interferenzschichtsystem weist mit anderen Worten eine geringere Toleranz für Änderungen der Schichtdicke auf als die Einzelschicht. Mit dem erfindungsgemäßen Verfahren soll eine Entspiegelungsschicht hergestellt werden, die sowohl bei senkrechtem Lichteinfall als auch bei schrägem Lichteinfall eine besonders geringe Restreflexion aufweist.

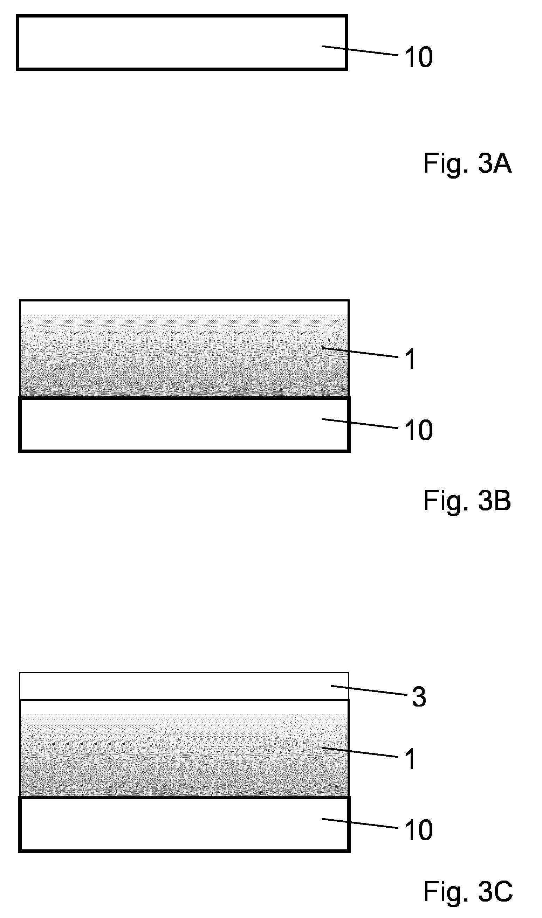

In den Figuren 3A bis 3F ist ein erstes Ausführungsbeispiel des Verfahrens zur Herstellung eines reflexionsmindernden Schichtsystems anhand von Zwischenschritten dargestellt.

Bei dem Ausführungsbeispiel des Verfahrens wird das in Figur 3A dargestellte Substrat 10 mit einem reflexionsmindernden Schichtsystem versehen. Bei dem dargestellten Ausführungsbeispiel ist das Substrat 10 ein ebenes Substrat. Alternativ könnte das Substrat 10 bei dem Verfahren insbesondere ein gekrümmtes Substrat sein, wie beispielsweise die in Figur 1 dargestellte sphärische Linse. Das Substrat 10 kann insbesondere ein Glas- oder Kunststoffsubstrat sein.

Bei dem in Figur 3B dargestellten Zwischenschritt ist eine Brechzahlgradientenschicht 1 durch Ko-Verdampfung eines anorganischen Materials und eines organischen Materials auf das Substrat 10 aufgebracht worden. Die Brechzahlgradientenschicht 1 enthält vorzugsweise MgF₂ oder SiO₂ als anorganisches Material und Melamin als organisches Material. Alternativ ist es möglich, dass die bevorzugten anorganischen Materialien MgF₂ oder SiO₂ mit einem anderen organischen Material kombiniert werden, beispielsweise mit einem der zuvor beschriebenen UV-absorbierenden organischen Materialien. Anstelle von MgF₂ können andere Fluoride wie zum Beispiel AlF₃ oder Fluoridmischungen wie zum Beispiel Krylit als anorganisches Material verwendet werden, wobei sich diese Fluoride durch eine besonders niedrige Brechzahl von n < 1,4 auszeichnen.

Die Ko-Verdampfung des anorganischen und des organischen Materials erfolgt vorzugsweise ionengestützt, wobei zum Beispiel mittels einer Plasmaionenquelle Ionen von Stickstoff oder einem anderen Inertgas mit einer maximalen Ionenenergie von etwa 45 eV bis 60 eV erzeugt werden, die während des Aufdampfens auf die Brechzahlgradientenschicht 1 auftreffen.

Die Brechzahlgradientenschicht 1 weist vorzugsweise eine Dicke von 70 nm bis 200 nm, bevorzugt etwa 150 nm auf. Die Konzentration des organischen Materials beträgt in einem Bereich an der Grenzfläche zum Substrat 10 vorzugsweise nicht mehr als 95 %. In dem Bereich an der Grenzfläche zum Substrat 10 ist die Konzentration des organischen Materials vorzugsweise derart gewählt, dass die Brechzahl der Brechzahlgradientenschicht 1 in diesem Bereich an die Brechzahl des Substrats 10 angepasst ist. "Angepasst" bedeutet in diesem Zusammenhang insbesondere, dass die Brechzahl der Brechzahlgradientenschicht an der Grenzfläche zum Substrat um nicht mehr als 0,1, bevorzugt nicht mehr als 0,05, von der Brechzahl des Substrats abweicht.

In einem Bereich an der vom Substrat 10 abgewandten Grenzfläche beträgt die Konzentration des organischen Materials bevorzugt weniger als 5 %. Die Dicke dieses Bereichs kann vorteilhaft mindestens 30%, bevorzugt mindestens 40% oder sogar mindestens 50% der Gesamtdicke der Brechzahlgradientenschicht 1 betragen.

Bei dem in Figur 3C dargestellten Verfahrensschritt ist eine anorganische Zwischenschicht 3, die vorzugsweise SiO₂ enthält, auf die Brechzahlgradientenschicht 1 aufgebracht worden. Die anorganische Zwischenschicht weist vorzugsweise eine Dicke zwischen 2 nm und 15 nm auf und wird während des Aufwachsens vorzugsweise durch Ionenbeschuss mit Argon- oder Sauerstoffionen verdichtet.

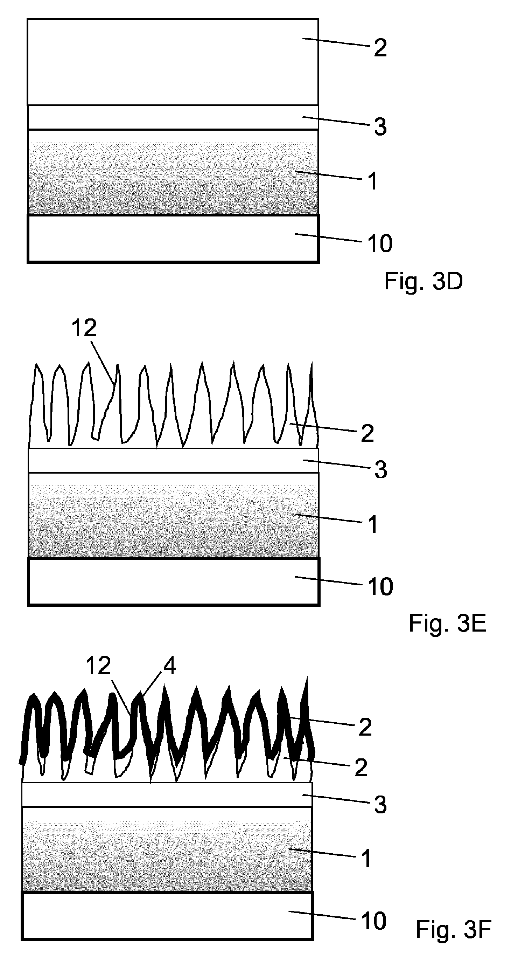

In dem in Figur 3D dargestellten weiteren Verfahrensschritt ist eine organische Schicht 2 über der Brechzahlgradientenschicht 1 und der Zwischenschicht 3 aufgebracht worden. Die Herstellung der organischen Schicht 2 erfolgt wie die Herstellung der Brechzahlgradientenschicht 1 vorzugsweise durch ionengestütztes Aufdampfen mittels einer Plasmaionenquelle, die Ionen von Stickstoff oder einem anderen Inertgas mit einer maximalen Ionenenergie von etwa 45 eV bis 60 eV erzeugt. Die organische Schicht 2 wird vorzugsweise mit einer Dicke zwischen 250 nm und 450 nm aufgebracht. Das Material der organischen Schicht 2 ist vorzugsweise Melamin.

Bei dem in Figur 3E dargestellten Zwischenschritt des Verfahrens ist durch einen Plasmaätzprozess eine Nanostruktur 12 in der organischen Schicht 2 erzeugt worden, wobei die Nanostruktur durch eine Vielzahl von Strukturelementen in Form von Erhebungen und Vertiefungen gebildet ist. Die Höhen der Strukturelemente (Spitze-zu-Tal) betragen bevorzugt im Mittel zwischen 80 nm und 130 nm, und deren Abstände (Spitze-zu-Spitze) vorzugsweise nicht mehr als 100 nm. Bei dem Plasmaätzprozess wird die Oberfläche des Substrats 10 beispielsweise mittels einer Plasmaionenquelle mit Ionen beschossen, um die Nanostruktur 12 zu erzeugen. Ein solcher Plasmaätzprozess ist an sich aus den in der Beschreibungseinleitung zitierten Druckschriften DE 10241708 B4 oder DE 102008018866 A1 bekannt und wird daher nicht näher erläutert.

Vor der Durchführung des Plasmaätzprozesses kann eine dünne Initialschicht (nicht dargestellt) auf die zu strukturierende Oberfläche aufgebracht werden, die vorzugsweise eine Dicke von nur etwa 2 nm aufweist. Bei der Initialschicht handelt es sich vorzugsweise um eine dünne Oxidschicht, Nitridschicht oder Fluoridschicht. Diese Vorgehensweise ist an sich aus der Druckschrift DE 102008018866 A1 bekannt.

Durch die Nanostruktur wird ein Brechzahlgradient in der organischen Schicht 2 erzeugt, der in einer vom Substrat 10 zur Oberfläche zeigenden Richtung abnimmt. Die mittlere effektive Brechzahl der Nanostruktur 12 beträgt bevorzugt weniger als 1,2. Vorzugsweise entsteht an der Oberfläche ein Bereich von mindestens 100 nm Dicke mit einer Brechzahl von weniger als 1,15.

Der Brechzahlgradientenschicht 1 folgt somit eine zweite durch die Nanostruktur 12 in der vergangenen Schicht 2 gebildete zweite Brechzahlgradientenschicht nach, in der die Brechzahl auf einen noch geringeren Wert abfällt. Vorzugsweise nimmt die Brechzahl in der gesamten reflexionsmindernden Schichtenfolge in Richtung vom Substrat 10 zur Oberfläche hin ab. Auf diese Weise wird eine insgesamt sehr dicke Brechzahlgradientenschicht erzeugt, die eine besonders gute Entspiegelung über einen großen Winkel- und Wellenlängenbereich bewirkt. Insbesondere hat sich herausgestellt, dass die mit dem Verfahren hergestellte reflexionsmindernde Schichtenfolge auch bei gekrümmten Substraten eine sehr gute Entspiegelung bis in die Randbereiche des Substrats bewirkt, da die mit dem Verfahren hergestellte Entspiegelungsschicht vergleichsweise tolerant gegenüber Änderungen der Schichtdicke ist.

Bei einer vorteilhaften Ausgestaltung des Verfahrens wird, wie in Figur 3F dargestellt, eine Schutzschicht 4 auf die Nanostruktur 12 aufgebracht. Die Schutzschicht 4 weist vorzugsweise eine Dicke von 10 nm bis 50 nm, bevorzugt weniger als 30 nm, auf und kann beispielsweise eine SiO₂-Schicht sein. Die Schutzschicht 4 dient insbesondere zum Schutz der aus dem organischen Material der organischen Schicht 2 bestehenden Nanostruktur 12 vor äußeren Einflüssen, insbesondere vor einer mechanischen Beschädigung.

Bei einem Ausführungsbeispiel des Verfahrens wurde eine reflexionsmindernde Schichtenfolge hergestellt, wobei der Ablauf des Verfahrens den Figuren 3A bis 3F entspricht. Dabei wurde eine Kunststofflinse 10 aus einem Polycarbonat (Makrolon) mit der reflexionsmindernden Schichtenfolge versehen. Auf das Kunststoffsubstrat 10 wurde durch Ko-Verdampfung des organischen UV-Absorbers Methyl-2-cyano-3(4-hydroxyphenyl)acrylat (erhältlich unter der Bezeichnung SEMAsorb 20163) und MgF₂ eine Brechzahlgradientenschicht 1 mit einer Dicke von 300 nm aufgebracht.

Die Brechzahl wurde durch die Mischung der Materialien mit den Brechzahlen 1,7 @ 500nm (SEMAsorb 20163) und 1,38 (MgF2) so angepasst, dass die effektive Brechzahl in einem Bereich am Substrat 1,55 beträgt und sich graduell auf bis auf 1,38 in einem Bereich an der Oberfläche verringert. Der Anteil des organischen Materials beträgt am Substrat 10 etwa 60% und innerhalb der letzten 20 nm an der Oberfläche der Brechzahlgradientenschicht 10 weniger als 5%. Insgesamt beträgt der Anteil des organischen Materials in der Brechzahlgradientenschicht 10 etwa 40%.

Durch Aufdampfen wurde anschließend im gleichen Vakuumprozess zunächst eine etwa 5 nm dicke anorganische Zwischenschicht 3 aus SiO₂ zur Haftvermittlung und dann eine 250 nm dicke organische Schicht 2 aus Melamin aufgebracht. Während des Aufdampfens der SiO₂-Schicht 3 wurden mit Hilfe einer Plasmaionenquelle Argon und Sauerstoff-Ionen in Richtung der wachsenden SiO₂-Schicht 3 beschleunigt, wobei die Ionenquelle mit Ar- und O₂-Flussraten von jeweils 10 sccm betrieben wurde und Ionenenergien zwischen 60 eV und 120 eV erzeugt wurden.

Das Aufdampfen der organischen Schicht 2 aus Melamin erfolgte mit Ionenstützung durch ein Inertgas und einer maximalen Ionenenergie von 60 eV, unter Zugabe von Ar mit einer Flussrate bis zu 10 sccm. Anschließend wurde mit einer geeigneten Ionenquelle, die Ionen mit einer mittleren Energie von 80 eV (40 eV bis 160 eV) erzeugt, eine Nanostruktur 12 in die Melaminschicht 2 geätzt. Die Nanostruktur 12 in der auf diese Weise hergestellten organischen Schicht 2 weist Strukturelemente mit Höhen von mindestens 80 nm und maximal 140 nm je nach Ätzzeit und Ionenenergie auf. Zum Abschluss wurde eine 20 nm dicke Schutzschicht 4 aus SiO₂ aufgebracht. Die mittlere effektive Brechzahl der nanostrukturierten organischen Schicht 2 einschließlich der Schutzschicht 4 liegt im Bereich von 1,05 bis 1,15.

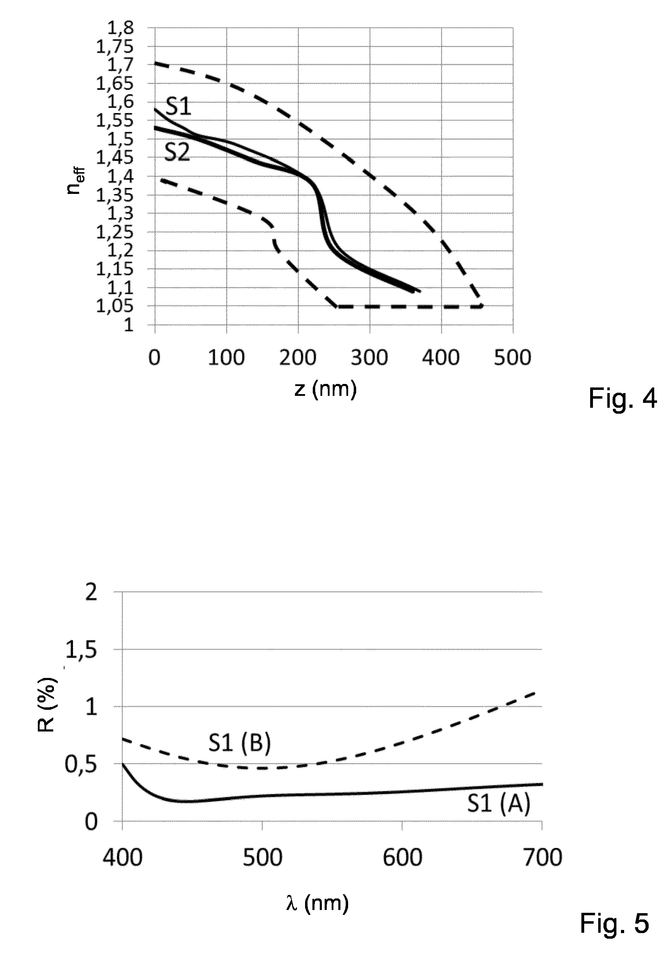

Der Verlauf der effektiven Brechzahl n_{eff} in Abhängigkeit einer vom Substrat ausgehenden Ortskoordinate z des auf diese Weise hergestellten ersten Ausführungsbeispiels des reflexionsmindernden Schichtsystems ist in Figur 4 (Kurve S1) im Vergleich zu einem im Folgenden erläuterten zweiten Ausführungsbeispiel (Kurve S2) dargestellt. Die gestrichelten Linien markieren einen Bereich sinnvoller Brechzahlverläufe, die mit dem Verfahren realisiert werden können.

In Figur 5 ist die Reflexion R in Abhängigkeit von der Wellenlänge λ für das erste Ausführungsbeispiel des reflexionsmindernden Schichtsystems dargestellt, wie sie an Positionen A und B der gekrümmten Linse gemäß Figur 1 auftritt. Das reflexionsmindernde Schichtsystem weist im Mittenbereich der gekrümmten Linse eine Gesamtschichtdicke von 370 nm auf und erreicht eine mittlere Restreflexion von < 0.4% im Spektralbereich von 400 nm bis 700 nm. Im Randbereich der Linse, in dem der Dampfeinfallswinkel bis zu 60° beträgt und die Schichtdicke auf 50% abgefallen ist, wird eine mittlere Restreflexion von < 1% erreicht.

Bei einem zweiten Ausführungsbeispiel wurde als Substrat 10 eine Linse aus einem Cycloolefin-Polymer (Zeonex) verwendet. Durch Ko-Verdampfung von Melamin und MgF₂ wurde eine Brechzahlgradientenschicht 1 mit graduell abnehmender Brechzahl und einer Dicke von 250 nm aufgebracht. Der Anteil von Melamin beträgt im Bereich an der Grenzfläche zum Substrat etwa 25 % und innerhalb der letzten 50 nm an der Oberfläche der Brechzahlgradientenschicht 1 weniger als 5 %. Durch Aufdampfen wurde anschließend im gleichen Prozess eine 300 nm dicke Melamin-Schicht 2 aufgebracht. Anschließend wurde mit einer geeigneten Ionenquelle, die Ionen mit einer mittleren Energie von 80 eV (40 eV bis 160 eV) erzeugt, eine Nanostruktur 12 in die Melaminschicht 2 geätzt. Die Nanostruktur 12 in der auf diese Weise hergestellten organischen Schicht 2 weist Strukturelemente auf, deren Abstände im Mittel nicht mehr als 100 nm betragen. Zum Abschluss wurde eine 25 nm dicke Schutzschicht 4 aus SiO₂ durch Aufdampfen aufgebracht. Das SiO₂ scheidet sich bei dem gerichteten Prozess bevorzugt auf den Kuppen der Strukturen ab, so dass sich der Füllfaktor und die Form der Nanostruktur 12 geringfügig ändern. Die Dicke der nanostrukturierten organischen Schicht 2 einschließlich der Schutzschicht 4 beträgt mindestens 100 nm und maximal 130 nm.

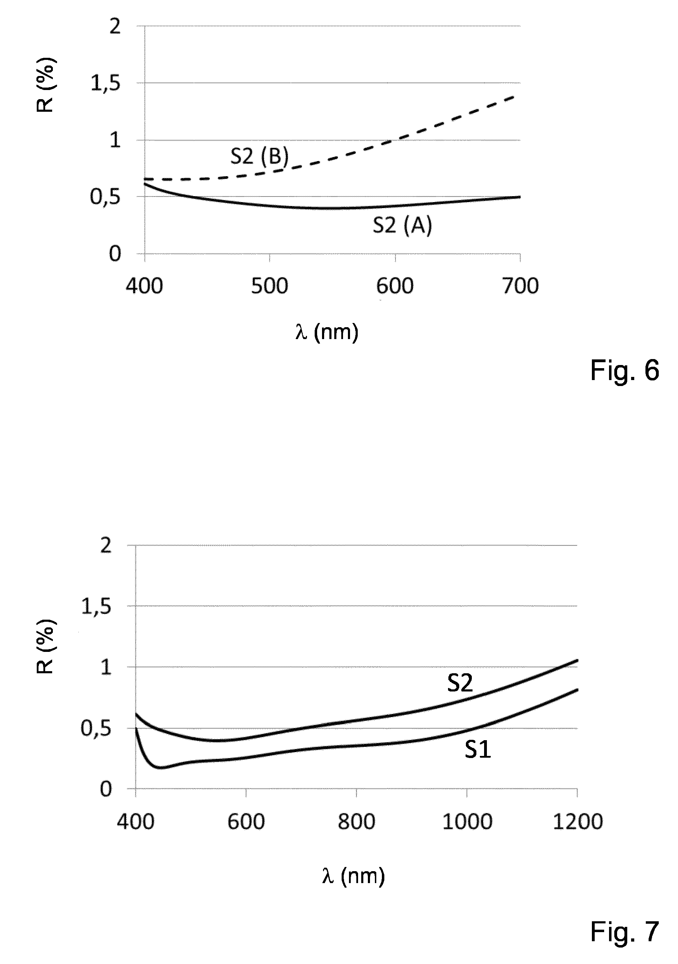

In Figur 6 ist die Reflexion R in Abhängigkeit von der Wellenlänge λ für das zweite Ausführungsbeispiel des reflexionsmindernden Schichtsystems dargestellt, wie sie an Positionen A und B der gekrümmten Linse gemäß Figur 1 auftritt. Das reflexionsmindernde Schichtsystem weist im Mittenbereich der gekrümmten Linse eine Gesamtschichtdicke von 360 nm auf und erreicht eine mittlere Restreflexion von 0,5 % im Spektralbereich von 400 nm bis 700 nm. Im Randbereich der Linse, in dem der Dampfeinfallswinkel bis zu 60° beträgt und die Schichtdicke auf 50% abgefallen ist, wird eine mittlere Restreflexion < 1% erreicht.

Figur 7 zeigt für beide Ausführungsbeispiele S1 und S2 die Reflexion R in Abhängigkeit von der Wellenlänge λ in einem größeren Wellenlängenbereich von 400 nm bis 1200 nm.

Die in den Figuren 5 bis 7 dargestellten Reflexionsspektren verdeutlichen, dass die Entspiegelungsschicht, die mit dem hierin beschriebenen Verfahren hergestellt wird, eine besonders geringe Restreflexion auch an Positionen auf gekrümmten Substraten aufweist, an denen aufgrund eines erhöhten Dampfeinfallswinkels beim Beschichtungsprozess reduzierte Schichtdicken auftreten. Weiterhin ist die mit dem Verfahren hergestellte Entspiegelungsschicht auch für ebene Substrate von Vorteil, wenn eine besonders geringe Restreflexion bei großen Lichteinfallswinkeln, beispielsweise bei Einfallswinkeln bis zu 80°, und/oder über einen großen Wellenlängenbereich, beispielsweise von 400 nm bis 1200 nm, erzielt werden soll.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Herstellung eines reflexionsmindernden Schichtsystems auf einem Substrat (10), umfassend die Schritte:
- Abscheidung einer Brechzahlgradientenschicht (1) auf dem Substrat (10) durch Ko-Verdampfung eines anorganischen Materials und eines organischen Materials, wobei die Brechzahlgradientenschicht (1) eine in Wachstumsrichtung abnehmende Brechzahl aufweist,
- Abscheidung einer organischen Schicht (2) über der Brechzahlgradientenschicht (1), und
- Erzeugung einer Nanostruktur (12) in der organischen Schicht (2) durch einen Plasmaätzprozess.

2. Verfahren nach Anspruch 1,
wobei die Nanostruktur (12) eine Vielzahl von Strukturelementen aufweist, deren Höhen im Mittel zwischen 80 nm und 130 nm und deren Abstände im Mittel weniger als 100 nm betragen.

3. Verfahren nach einem der vorhergehenden Ansprüche,
wobei das anorganische Material der Brechzahlgradientenschicht (1) einen Brechungsindex n1 mit 1,37 ≤ n1 ≤ 1,46 aufweist, und wobei das organische Material der Brechzahlgradientenschicht (1) einen Brechungsindex n2 > n1 mit 1,6 ≤ n2 ≤ 1,9 aufweist.

4. Verfahren nach einem der vorhergehenden Ansprüche,
wobei die Brechzahl der Brechzahlgradientenschicht (1) an einer Grenzfläche zum Substrat (10) an eine Brechzahl des Substrats (10) angepasst ist.

5. Verfahren nach einem der vorhergehenden Ansprüche,
wobei das organische Material ein UV-absorbierendes Material ist.

6. Verfahren nach einem der vorhergehenden Ansprüche,
wobei die organische Schicht (2) zumindest bereichsweise eine effektive Brechzahl zwischen 1,05 und 1,38 aufweist.

7. Verfahren nach einem der vorhergehenden Ansprüche,
wobei vor der Abscheidung der organischen Schicht (2) eine anorganische Zwischenschicht (3) auf der Brechzahlgradientenschicht (1) abgeschieden wird.

8. Verfahren nach einem der vorhergehenden Ansprüche,
wobei nach der Erzeugung der Nanostruktur (12) eine Schutzschicht (4) mit einer Dicke zwischen 10 nm und 50 nm auf die Nanostruktur (12) aufgebracht wird.

9. Verfahren nach einem der vorhergehenden Ansprüche,
wobei das gesamte reflexionsmindernde Schichtsystem in einem Vakuumprozess hergestellt wird.

10. Verfahren nach einem der vorhergehenden Ansprüche,
wobei die organische Schicht (2) durch plasmaionengestützte Abscheidung unter Verwendung einer Plasma-Ionenquelle abgeschieden wird, und wobei die Nanostruktur (12) nachfolgend durch eine Erhöhung der Ionenenergie und/oder eine Änderung des Prozessgases der Plasma-Ionenquelle erzeugt wird.

11. Verfahren nach einem der vorhergehenden Ansprüche,
wobei die organische Schicht (2) Melamin aufweist.

12. Reflexionsminderndes Schichtsystem, umfassend
- eine Brechzahlgradientenschicht (1), die ein anorganisches Material und ein organisches Material in einer räumlich variierenden Zusammensetzung aufweist, wobei die Brechzahlgradientenschicht eine in Wachstumsrichtung abnehmende Brechzahl aufweist, und
- eine über der Brechzahlgradientenschicht (1) angeordnete organische Schicht (2), die eine mit einer Nanostruktur (12) versehene Oberfläche aufweist.

13. Reflexionsminderndes Schichtsystem nach Anspruch 12,
wobei die Nanostruktur (12) eine Vielzahl von Strukturelementen aufweist, deren Höhen im Mittel zwischen 80 nm und 130 nm und deren Abstände im Mittel weniger als 100 nm betragen.

14. Reflexionsminderndes Schichtsystem nach Anspruch 12 oder 13,
wobei die Brechzahl der Brechzahlgradientenschicht (1) an einer Grenzfläche zu einem Substrat (10) des reflexionsmindernden Schichtsystems an eine Brechzahl des Substrats (10) angepasst ist.

15. Reflexionsminderndes Schichtsystem nach einem der Ansprüche 12 bis 14,
wobei eine Gesamtdicke des reflexionsmindernden Schichtsystems zwischen 250 nm um 450 nm beträgt.
